# EUROPEAN PATENT APPLICATION

(11) **EP 2 455 978 A1**
(43) Date of publication of application: **23.05.2012**
(21) Application number: 10799759.5
(22) Date of filing: 06.07.2010
(51) Int. Cl.: H01L 31/042, B32B 9/00, B32B 27/18, B32B 27/30

(54) **BACKSIDE PROTECTIVE SHEET FOR SOLAR CELLS AND PROCESS FOR PRODUCTION OF SAME**

(30) Priority: 15.07.2009 JP 2009166614; 17.12.2009 JP 2009286598
(71) Applicant: NHK Spring Co., Ltd., Kanagawa 236-0004 (JP)
(72) Inventor: ICHIMURA, Shigeki, Yokohama-shi Kanagawa 236-0004 (JP); NATSUME, Yutaka, Yokohama-shi Kanagawa 236-0004 (JP); SAKAI, Toru, Yokohama-shi Kanagawa 236-0004 (JP)
(74) Representative: Wiedemann, Peter
(86) International application number: PCT/JP2010/061483
(87) International publication number: WO 2011/007700

(57) **Abstract**

The solar cell back surface protection sheet of the present invention includes a substrate film composed of at least one layer, and a coating layer composed of at least one layer and formed on one surface or both surfaces of the substrate film, wherein the coating layer is a ternary copolymer layer formed by curing a coating film of a liquid containing a resin component composed of a metal alkoxide having a reactive functional group (Y), an acrylic monomer having a reactive functional group (X) that is reactive with the reactive functional group (Y), and an acrylic monomer having no reactive functional group (X). The manufacturing method of the present invention can provide a solar cell back surface protection sheet that can satisfy a gas barrier property, an anti-weathering property, and flexibility all together.

## Description

### Field

The present invention relates to a solar cell back surface protection sheet that has an excellent anti-weathering property, an excellent water vapor barrier property, and flexibility that prevents deterioration of a water vapor barrier property even when the sheet is bent in a certain degree in a fixed molding process such as hot press molding and vacuum/pressure molding during manufacturing of a solar cell panel, and a method of manufacturing the solar cell back surface protection sheet.

### Background

Several proposals have been made for a structure of a back surface protection sheet included in a solar cell module. As such a sheet with features for imparting a barrier property against gases such as water vapor and oxygen gas, a multilayered structure in which films having different properties are bonded with each other with an adhesive is mainly used.

For example, Patent Literature 1 discloses a structure using aluminum foil so as to ensure the gas barrier property. Patent Literature 2 discloses a structure in which a film having an oxide vapor-deposited film provided on a surface thereof to ensure the gas barrier property is bonded to another film with an adhesive. Patent Literature 3 discloses a multilayered structure formed of a combination of an oxide vapor-deposited film and a coating layer of a complex containing a hydrolysis product of a metal alkoxide and a water-soluble polymer.

### Citation List

### Patent Literatures

Patent Literature 1: Japanese Utility Model Application Laid-open No. H2-44995 U
Patent Literature 2: Japanese Patent Application Laid-open No. 2002-134771 A
Patent Literature 3: Japanese Patent Application Laid-open No. 2006-253264 A

### Summary

### Technical Problem

In the sheet using aluminum foil as disclosed in Patent Literature 1, the aluminum foil has an excellent gas barrier property. However, a resin film included in the sheet may be softened by heat of about 150°C applied by hot pressing for manufacturing a solar cell module. A projection of a solar cell element electrode may pass through the softened resin film layer. When such an incident occurs, the electrode comes into contact with the aluminum foil to cause a short circuit, thereby adversely affecting the cell performance.

The sheet using an inorganic oxide vapour-deposited film as disclosed in Patent Literature 2 has poor flex resistance because the inorganic oxide vapor-deposited film has a glassy film structure. Accordingly, there is a problem that mechanical stress on the film causes cracks which remarkably deteriorate the gas barrier property of the sheet. In addition, when the thickness of the vapor-deposited film is reduced so as to have a certain level of flexibility, defects occur in the film, resulting in a lowered gas barrier property.

In the sheet as disclosed in Patent Literature 3, gas barrier property is ensured by providing, on the inorganic oxide vapor-deposited layer, the coating layer of the complex of a water-soluble polymer such as polyvinyl alcohol (PVA) and one or more kinds of metal alkoxides and/or hydrolysis products thereof. However, polymer such as PVA has an insufficient water vapor barrier property. Additionally, the sheet is inevitably deteriorated by ultraviolet rays because thereby the C-C bond of the main chain of the polymer is easily severed. Therefore the gas barrier property and the anti-weathering property of the polymer are not reliable in a long period of time unless the polymer is combined with an oxide vapor-deposited film. Forming of an oxide vapor-deposited film on the surface of a substrate film requires large-scale equipment with a vacuum system. In addition, after the oxide vapor-deposited film is formed, it is required to perform a step of applying the complex of the water-soluble polymer and the metal alkoxide(s) and/or the hydrolysis product(s) thereof, which increases the manufacturing steps. As a result, the sheet has a problem of high manufacturing costs.

In any of the aforementioned sheets, in order to impart an anti-weathering property, a resin film having anti-weathering property, such as a fluorine resin and an olefinic resin, is bonded on one surface or both surfaces of the gas barrier layer (a substrate film) with, e.g., an adhesive. The resin films are inevitably deteriorated by ultraviolet rays because thereby the C-C bond of the main chain of the resins is easily severed. As a result, together with the deterioration of the anti-weathering resin films due to ultraviolet rays, the deterioration of the gas barrier property proceeds. With the proceeding of the deterioration of the gas barrier property, permeation of water vapor from outside to inside of the back surface protection sheet occurs. The water vapor then hydrolyzes the adhesive of the adhesive layer bonding the substrate film, and causes deterioration of the adhesive. As a result, a problem arises in that the substrate film and the anti-weathering resin film will peel off.

The present invention is made in view of the *aforementioned* problems of the related art, and aims to provide a solar cell back surface protection sheet that can satisfy an anti-weathering property, a gas barrier property, and flexibility all together, and a method of manufacturing such a solar cell back surface protection sheet.

### Solution to Problem

In order to solve the aforementioned problems, the present invention provides a solar cell back surface protection sheet employing the following structures, and a method of manufacturing such a solar cell back surface protection sheet.

(1) A solar cell back surface protection sheet, comprising:
   a substrata film composed of at least one layer; and
   a coating layer formed on one surface or both surfaces of the substrate film and composed of at least one layer, wherein
   the coating layer is a ternary copolymer layer that is formed by curing a coating film of a liquid containing a resin component consisting of a metal alkoxide having a reactive functional group (Y), an acrylic monomer having a reactive functional group (X) that is reactive with the reactive functional group (Y), end an acrylic monomer having no reactive functional group (X).
(2) The solar cell back surface protection sheet according to the aforementioned (1), wherein the substrate film is a layered film composed of two or more films bonded with each other with a silane adhesive.
(3) The solar cell back surface protection sheet according to the aforementioned (1), wherein the substrate film is a single layer, and the single layer is a film having an inorganic oxide vapor-deposited film.
(4) The solar cell back surface protection sheet according to the aforementioned (1) or (2), wherein the substrata film is composed of two or more layers, and at least one layer of the layers is a film having an inorganic oxide vapor-deposited film.
(5) The solar cell back surface protection sheet according to any one of the aforementioned (1) to (4), wherein a material of the substrate film is at least one kind selected from a polyester resin, a polyolefin resin, a polystyrene resin, a polyamide resin, a polycarbonate resin, and a polyacrylonitrile resin.
(6) The solar cell back surface protection sheet according to any one of the aforementioned (1) to (5), wherein, when the coating layer is composed of a single layer, an ultraviolet scattering agent or/and an ultraviolet absorbing agent are mixed in the single layer, and when the coating layer has a multilayered structure, an ultraviolet scattering agent or/and an ultraviolet absorbing agent are mixed in at least one layer of the multilayered structure.
(7) A method of manufacturing a solar cell back surface protection sheet, comprising:
   preparing a substrate film composed of at least one layer;
   preparing a liquid containing a resin component consisting of a metal alkoxide having reactive functional group (Y), an acrylic monomer having a reactive functional group (X) that is reactive with the reactive functional group (Y), and an acrylic monomer having no reactive functional group (X);
   applying the liquid on one surface or both surfaces of the substrate films so as to form a coating film composed of at least one layer; and
   curing the coating film composed of at least one layer so as to form a coating layer composed of at least one layer of a ternary copolymer layer.
(8) The method of manufacturing a solar cell back surface protection sheet according to the aforementioned (7), wherein the liquid is an emulsion obtained by dispersing in a water-based solvent a resin component consisting of a metal alkoxide having a reactive functional group (Y), an acrylic monomer having a reactive functional groups (X) that is reactive with the reactive functional group (Y), and an acrylic monomer having no reactive functional group (X).
(9) The method of manufacturing a solar cell back surface protection sheet according to the aforementioned (7), wherein the liquid is a resin solution obtained by dissolving in a non-water-based solvent a resin component consisting of a metal alkoxide having a reactive functional group (Y), an acrylic monomer having a reactive functional group (X) that is reactive with the reactive functional group (Y), and an acrylic monomer having no reactive functional group (X).
(10) The method of manufacturing a solar cell back surface protection sheet according to any one of the aforementioned (7) to (9), wherein the substrate film is a layered film composed of two or more films bonded with each other with a silane adhesive.
(11) The method of manufacturing a solar cell back surface protection sheet according to any one of the aforementioned (7) to (10), wherein the substrate film is a single layer, and the single layer is a film having an inorganic oxide vapor-deposited film.
(12) The method of manufacturing a solar cell back surface protection sheet according to any one of the aforementioned (7) to (10), wherein the substrate film is composed of two or more layers, and at least one layer of the layers is a film having an inorganic oxide vapor-deposited film.
(13) The method of manufacturing a solar cell back surface protection sheet according to any one of the aforementioned (7) to (12), wherein a material of the substrate film is at least one wind selected from a polyester resin, a polyolefin resin, a polystyrene resin, a polyamide resin, a polycarbonate resin, and a polyacrylonitrile resin.
(14) The method of manufacturing a solar cell back surface protection sheet according to any one of the aforementioned (7) to (13), wherein, at the preparation of the liquid, when the ternary copolymer layer is composed of a single layer, an ultraviolet scattering agent or/and an ultraviolet absorbing agent are mixed in a liquid for forming the single layer, and when the ternary copolymer layer has a multilayered structure, an ultraviolet scattering agent or/and an ultraviolet absorbing agent are mixed in a liquid for forming at least one layer of the multilayered structure.

### Advantageous Effects of Invention

The solar cell back surface protection sheet according to the present invention has good practical utility and can satisfy an anti-weathering property, a gas barrier property, and flexibility all together. The method for manufacturing a solar cell back surface protection sheet according to the present invention can provide a solar cell back suffice protection sheet that has good practical utility and can satisfy an anti-weathering property, a gas barrier property, and flexibility all together.

### Brief Description of Drawings

FIG. 1 is a cross-sectional view illustrating an example of a solar cell back surface protection sheet according to the present invention.
FIG. 2 is a schematic view to explain characteristics of a ternary copolymer constituting a coating layer of the solar cell back surface protection sheet according to the present invention.
FIG. 3 is a schematic view to explain characteristics of a copolymer constituting a complex coating layer of a related-art solar cell back surface protection sheet,
FIG. 4 is a schematic view to explain a sell-repairing characteristic of the ternary copolymer included in the coating layer of the solar cell back surface protection sheet according to the present invention.
FIG. 5 is a graph illustrating an infrared total reflection-absorption spectrum of a dried coating film of a base resin of a commercially supplied emulsion used as a material for the liquid used in the present invention.
FIG. 6 is a graph illustrating an infrared total reflection-absorption spectrum of a ternary copolymer layer produced in Examples 1.
FIG. 7 is a graph illustrating an infrared total reflection-absorption spectrum of a ternary copolymer layer produced in Example 4.

### Description of Embodiments

A solar cell back surface protection sheet according to the present invention includes a substrate film composed of at least one layer, and a coating layer composed of at least one layer and formed on one surface or both surfaces of the substrate films, **characterized in that** the coating layer is a ternary copolymer layer formed by curing a coating film of a liquid containing a resin component consisting of a metal alkoxide having a reactive functional group (Y), an acrylic monomer having a reactive functional group (X) that is reactive with the reactive functional group (Y), and an acrylic monomer having no reactive functional group (X).

A method of manufacturing a solar cell back surface protection sheet according to the present invention includes a step of preparing a substrate film composed of at least one layer, a step of preparing a liquid containing a resin component consisting of a metal alkoxide having a reactive functional group (Y), an acrylic monomer having a reactive functional group (X) that is reactive with the reactive functional group (Y), and an acrylic monomer having no reactive functional group (X), a step of applying the liquid on one surface or both surfaces of the substrate film and forms a coating film composed of at least one layer, and a step of curing the coating film composed of at least one layer so as to form a coating layer composed of at least one layer of a ternary copolymer layer.

The term "a liquid containing a resin component consisting of a metal alkoxide having a reactive functional group (Y), an acrylic monomer having a reactive functional group (X) that is reactive with the reactive functional group (Y), and an acrylic monomers having no reactive functional group (X)" means a water-based emulsion containing a resin component consisting of only the three kinds of monomers with a predetermined concentration (preferably final concentration of 50 weight percent), and a resin solution obtained by dissolving in a non-water-based solvent the resin component consisting of only the three kinds of monomers.

The substrate film may be of a single layer structure, and may also be of a multilayered structure composed of two or more layers. The coating layer is formed on one surface or both surfaces of the substrate film composed of the single layer or the multilayered structure of two or more layers. The coating layer formed on one surface or both surfaces of the substrate film is the ternary copolymer layer that is formed by polymerizing and curing the coating film of the liquid containing the resin component consisting of the metal alkoxide having the reactive functional group (X) , the acrylic monomer having the reactive functional group (X) that is reactive with the reactive functional group (Y), and the acrylic monomer having no reactive functional group (X) . The coating film may be formed as a single layer or as multiply layers.

When the substrate film is formed as the multilayered structure, it is preferable that a silane adhesive layer is interposed in each interface of the substrate film layers. At least one layer of the substrate film composed of at least one layer is preferably a film layer having an inorganic oxide vapor-deposited film. That is, when the substrate film is composed of a single layer, it is preferable that the film layer is the film layer having the inorganic oxide vapor-deposited film. When the substrate film is formed as the multilayered structure, it is preferable that at least one layer of the film layers is the layer having the inorganic oxide vapor-deposited film. In this case, the film layers are bonded with each other with the silane adhesive interposed in each interlace.

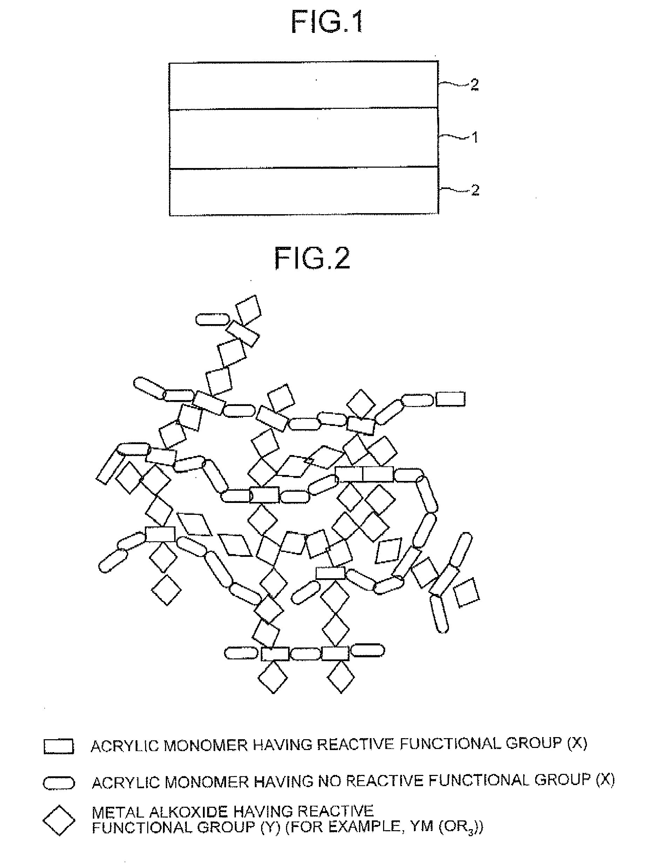

FIG. 1 is a view illustrating a cross-sectional structure of an embodiment of the solar cell back surface protection sheet of the present invention. FIG. 1 illustrates a multilayered structure wherein a substrate film 1 is composed of a single layer, and coating layers 2 are formed on both surfaces of the substrate film 1. The elements of the structure will be described hereinbelow with reference to FIG. 1.

### (Step of preparing substrate film)

The film for use as the substrate film 1 may be a resin film that is capable of being molded four a predetermined heating period of time that is appropriately adjusted within a range so as not to be melt or softened, because the film is heated in the hot pressing for forming a solar celt nodule. Examples of the material of the substrate film may include one or more kinds of resin selected from a polyester resin, a polyolefin ,resin, a polystyrene resin, a polyamide resin, a polycarbonate resin, and a polyacrylonitrile resin. Specifically, an engineering plastic film may be used as the substrate film 1, and examples of which may include a polyester film including a polyethylene terephthalate (PET) film, and a polyethylene naphthalate (PEN) film, a polyolefin film including a polyethylene film and a polypropylene film, a polystyrene films a polyamide film, a polycarbonate films, a polyacrylonitrile film, and a polyimide film. The thickness of the substrate film 1 is in a range from 3 to 300 µm,

The surface of the film is preferably processed to be oxidized by, e.g., irradiation with oxygen plasma or corona discharge, and flame treatment. The oxidization processing of the surface results in a large number of functional groups being present on the surface. The film having a large number of functional groups on the surface thereof tends to have good adhesiveness with the silane adhesive. Accordingly, the film whose surface is appropriately processed is preferably used as the substrate film 1.

The substrate film 1 is an example composed of a single layer. The film used as the single layer substrate film 1 may be a film having inorganic oxide vapor-deposited on the surface thereof. In the present invention, when the substrate film is formed as the multilayered structure, one or more layers of the multilayered structure may be a film layer having the inorganic oxide vapor-deposited film. The number of inorganic oxide vapor-deposited film layers built in the substrate film may be changed depending on a required gas barrier property. When the films each having the vapor-deposited film are bonded with each other, it is preferable that the surface having the vapor-deposited film of one film is bonded to a PET surface having no vapors deposited film of the other film.

Examples of inorganic oxide for vapor deposition may include silicon oxide, aluminum oxide, and zinc oxide. The thickness of the vapor-depoaited film is preferably from 1 nm to 100 nm.

As an adhesive used to bond the films witch each other, a variety of adhesives, such ass urethane, acrylic, epoxy, and silicons adhesives, have been used. Those adhesives have a problem of deterioration in adhesion performance caused by hydrolysis under high temperature and high humidity. In contrast, in the present invention, the silane adhesive is used for bonding the films to constitute the substrate film 1 in the multilayered structure. The silane adhesive has excellent adhesive performance even under high temperature and high humidity conditions.

Examples of the silane adhesive referred to herein may include a conventionally used silane coupling agent and a mixture containing alkoxysilane, which is a sort of the metal alkoxide compounds included in the components of the resin, (a ternary monomers) for forming the coating layer in the present invention.

In the silane adhesive, an alkoxy group of alkoxysilane is hydrolyzed to produce a silanol group (Si-OH). The silanol group reacts and bonds with a carboxyl group and a hydroxyl group that are present on the surface of the film and oxidized by oxygen plasma or corona discharge. Accordingly, the silane adhesive brings about good adhesion between the films. In addition, the silane adhesive is not hydrolyzed even under high temperature and high humidity conditions, and thereby keeps good adhesion property. Furthermore, a silanol bond has a high resistance against UV energy, accordingly, the silane adhesive has an excellent anti-weathering property.

When the substrate film 1 is composed of two or more film layers bonded with each other with the silane adhesive, the combination of the films may be any of a combination of the films of the same kind, a combination of the films of different kinds, a combination of the films of the same kind one of which has inorganic oxide vapor-deposited thereon, and a combination of the films of different kinds one of which has inorganic oxide vapor-deposited thereon.

### (step of preparing liquid)

The coating layer 2 is formed on one surface or both surfaces (in FIG. 1, on both surfaces) of the substrate film 1 with a thickness in a range from 5 to 300 µm. The coating layer 2 is the ternary copolymer layer formed by curing the coating film of the liquid containing the resin component consisting of the metal alkoxides having the reactive functional group (Y), the acrylic monomer having the reactive functional group (X), and the acrylic monomer having no reactive functional group (X). As referred to herein, the liquid is a wafer-based emulsion in which the resin component consisting of only the three kinds of monomers, i.e., the metal alkoxide having the reactive functional group (Y), the acrylic monomer having the reactive functional group (X) that is reactive with the reactive functional group (Y), and the acrylic monomer having no reactive functional group (X), is contained with a predetermined concentration (most preferably final concentration of 50 weight percent), or a resin solution in which the resin component consisting of only the three kinds of monomers is dissolved in a non-water-based solvent.

The metal alkoxide having the reactive functional group (Y) is a compound represented by any of the general formulae YM (OR)₃, YRM (OR)₂, and YR₂M (OR), where M is metal, R is an alkyl group, and Y is the reactive functional group.

Examples of the metal alkoxide having the reactive functional group (Y) may include one kind selected from or a mixture of α,β-ethylenically unsaturated monomers containing silane, such as: vinyltrimethoxysilane, vinyltriisopropoxysilane, allyltrimethoxysilane, diallyldimethylsilane, 3-methacryloxypropyltrimethoxysilane, 3-methacryloxypropylmethyldimethoxysilane 3-methaoryloxypropyltri-ethoxysilane, 3-mercaptopropyltriethoxysilane, 3-octanoylthio-1-propyltriethoxysilane 3-aminopropyltriethoxysilane, 3-aminopropyltrimethoxysilane, N-(2-aminoethyl)-3-aminopropylmethyldimethoxysilane, N-(2-aminoethyl)-3-aminopropyltrimethoxysilane, 3-ureidopropyltriethoxysilane, 3-isocyan.atepropyltriethoxysilane, and 3-isocyanatepropyltrimethoxysilane.

In addition to the metal alkoxide having the reactive functional group (Y), tetraalkoxysilane, trialkoxyaluminum, and tetraalkoxytitanium may be added.

When the metal alkoxide has an isocyanate group as the reactive functional group (Y), a capping agent (also called a blocking agent or a protecting agent) for the reactive functional group (Y) is used so as to suppress the direct reaction with water and effectively promote the reaction with the reactive functional group (X). As the capping agent, any suitable aliphatic, alicyclic, or aromatic alkyl mono-alcohol, or phenolic compounds may be used.

Examples of the aliphatic, alicyclic, or aromatic alkyl mono-alcohol may include: short chain aliphatic alcohol, such as ethanol, ethanol, n-butanol, 2-methyl-2-propanol, and 2-methyl-l-propanol; alicyclic alcohol such as cyclohexanol; and aromatic alkyl alcohol, such as phenylcarbinol, and methylphenylcarbinol.

Examples of the phenolic compounds may include phenol itself, and substituted phenol such as cresol and nitrophenol (the substitute group thereof does not affect coating operation).

As the capping agent, glycol ether may also be used in addition to the aforementioned substances. Examples of suitable glycol ether may include ethylene glycol butyl ether, diethylene glycol butyl ether, ethylene glycol methyl ether, and propylene glycol methyl ether. Diethylene glycol butyl ether is preferable among those glycol ethers.

Other examples of the capping agent may include: oximes such as methylethylketooxime, acetoneoxime, and cyclohexanoneoxime; lactams such as e-caprolactam; and amines such as dibutylamine.

A suitable capping may be selected and used so as to be appropriate for drying and reaction temperature of the coating film.

The reaction proceeds as follows. The capping agent modified on the isocyanate group in the emulsion is volatized (azeotropy) with water by being heated and dried after being applied, or decomposed by being heated, so that the capping agent is removed from the reactive functional group (isocyanate group). This triggers polymerization. The detachment reaction of the capping agent occurs upon heating at equal to or higher than 80°C. When the heating temperature exceeds 120°C, polymerization of the monomers rapidly proceeds. Accordingly, heating aiming at removal of the capping agent is preferably performed in a range from 80"C to 120"C. The detachment reaction of the capping agent simultaneously proceeds in a usual drying step of the coating film.

The reactive functional group (X) is a functional group that reacts and bonds with the reactive functional group (Y) of the metal alkoxide, such as an ester group, an epoxy group, a ketone group, an amino group, and a hydroxyl group.

Examples of the acrylic monomer having the reactive functional group (X) may include an α,β-ethylenically unsaturated monomer, e.g., ain α,β-ethylenically unsaturated monomer containing a hydroxyl group, such as: hydroxyethyl (meth)acrylate, 2-hydroxyethyl (meth)acrylate, hydroxypropyl (math)acrylate, hydroxybutyl (meth)acrylate, allyl alcohol, methacryl alcohol, 4-hydroxybutyl acrylate glycidyl(epoxy) ether, and an adduct of hydroxyethyl (meth)acrylate and e-caprolactone.

"The acrylic monomer has no reactive functional group (X)" means that the acrylic monomer does not have a functional groups that is reactive with then metal alkoxide having the reactive functional group (Y).
Examples of the acrylic monomer having no reactive functional group (X) may include α,β-ethylenically unsaturated monomers, such as (meth)acrylate ester (e.g., methyl (meth)acrylate, ethyl (meth)aorylate, n-propyl (meth)aarylate, isopropyl (methacrylate, n-butyl (meth) acrylate, isobutyl (roeth)acrylate, t-butyl (meth)acrylate, 2-ethylhexyl (meth)acrylate, lauryl methacrylate, phenyl acrylate, isobornyl (meth)acrylate, cyclohexyl methacrylate, t-butylcyclohexyl (meth) acrylate, dicyclopentadienyl (meth)acrylate, and dihydrodicyclopentadienyl (meth)acrylate), a polymerizable aromatic compound (e.g., styrene, a-methylstyrene, vinyl ketone, t-butylstyrene, para-chlorostyrene, and vinylnaphthalene), polymerizable nitrile (e.g., acrylonitrile, and methacrylonitrile), α-olefin (e.g., ethylene, and propylene), vinyl ester (e.g., vinyl acetate, and vinyl propionate), diene (e.g., butadiene, and isoprene), a polymerizable aromatic compound, polymerizable nitrile, α-olefin, vinyl ester, and diene.

The ternary copolymer layer obtained by polymerizing and curing the coating film of the liquid containing the resin component consisting of the three kinds of monomers may be obtained by simultaneous polymerization of the three kinds of monomers. Alternatively, the ternary copolymer layer may be obtained by mixing a combination of two kinds of monomers or partially polymerizing the combination of two kinds of monomers to be in a semi-polymerisation state, and thereafter mixing the resultant product and the remaining monomer and then polymerizing the mixture, to obtain the ternary copolymer layer, wherein the combination or two kinds of monomers may be either one of a combination of "then acrylic monomer having the reactive functional group (X)" and "the acrylic monomer having no reactive functional group (X)", a combination of "the acrylic monomer having the reactive functional group (X)" and "the metal alkoxide having the reactive functional group (Y)", and a combination of "the metal alkoxide having the reactive functional group (Y) and "the acrylic monomer having no reactive functional group (X)". Among these polymerization processes, the preferred process to be employed is the process in which the two kinds of monomers that are "the acrylic monomer having the reactive functional group (X)" and "the acrylic monomer having no reactive functional group (X)" are mixed or partially polymerized to be in a semi-polymerization state, and thereafter the mixture is further mixed with the remaining "metal alkoxide having the reactive functional group (Y)" and polymerized.

The ternary copolymer is obtained as the ternary copolymer layer, as a result of applying process on the substrate film. The sequence of the mixing of the monomers, applying, and polymerizing may be any one of the following: a sequence of mixing, polymerizing (semi-polymerization), applying (if any, after admixing the remaining monomer) , and then polymerizing (drying); and a sequence of mixing, applying, and then polymerizing (drying).

(Method of preparing emulsion with water-based solvent)
The water-based solvent for use may be, e,g, ion-exchanged water. If needed, a conventionally used dispersant may be added to an aqueous vehicle containing an organic solvent such as alcohol so as to enhance dispersing quality. Thereafter, a conventionally used homogenizer (e.g., "nor-300", a trade name of a product manufactured by Microtec Co., Ltd) may be used to process the water-based solvent so as to uniformly disperse the water-based solvent. Then, the aforementioned combination of the three kinds of monomers or two kinds of preliminary mixed monomers, and a polymerization initiator may be added dropwise into the water-based solvent while the water-based solvent is heated and stirred, to perform polymerization. The concentration of the resin component is preferably from 30 to 60 weight percent.

The aforementioned method can reduce deviation of the particle size of the resin component constituting the emulsion from the desired particle size. As a result, resin component particles within a preferable particle size range can be obtained.

Examples of the polymerization initiator may include: azo oil compounds (e.g., azobisisobutyronitrile, 2,2'-azobis(2-methylbutyronitrile), 2,2'-azobis(2-(2-imidazolin-2-yl)propane, and 2,2'-azobis(2,4-dimethylvaleronitrile); aqueous compounds (e.g., anionic compounds, such as 4,4'-azobis(4-cyanovaleric acid), 2,2-azobis(N-(2-carboxyethyl)-2-methylpropionamidine), and cationic compounds, such as 2,2'-azobis(2-methylpropionamidine); redox oil peroxides (e, g., benzoylperoxide, para-chlorebenioylperoxide, lauroylperoxide, and t-butyl perbenzoate); and aqueous peroxides (e.g., potassium persulfate, and ammonium persulfate).

In addition to the aforementioned dispersant, dispersants that are usually used by personas skilled in the art, and an emulsifying agent may be used together. Examples thereof may include Antox MS-60 (a trade name of a product manufactured by Nippon Nyukazai Co., Ltd.), Eleminol JS-2 (a trade name of a product manufactured by Sanyo Chemical Industries, Ltd.), Adekalia Soap NE-20 (a trade name of a product manufacture by Asahi Denka Co., Ltd), and Aquaron HS-10 (a trade name of a product manufactured by Daiichi Kogyo Seiyaku Co., Ltd).

The blend ratio of the conventionally used dispersant relative to the resin component consisting of the three kinds of monomers may be adjusted to a conventionally adopted ratio for preparing the emulsion. For example, the blend ratio may be adjusted such that the solid content weight ratio is in a range from 5/95 to 20/80. When the ratio is lower than 5/95, dispersed particles tend to be cohered to form aggregates which deteriorate smoothness of the coating film, whereas when the ratio exceeds 20/80, control of the film thickness tends to be difficult.

If necessary, it is allowable to use a chain transfer agent such as mercaptan such as laurylmercaptan, as well as α-methylstyrene dimer for adjusting molecular weight of the resin.

The polymerization reaction temperature of the mixed monomers is determined in accordance with the polymerization initiator, For example, when an azo-based initiator is used, preferable temperature is 60 to 90"C. When a redox-based initiator is used, preferable temperature is 30 to 70°C. The blend ratio of the initiator relative to the total amount of the emulsion is generally from 0.1 to 5 weight percent, and preferably from 0.2 to 2 weight percent.

As described above, the preferred process to be employed is the process in which the two kinds of monomers that are "the acrylic monomer having the reactive functional group (X)" and "the acrylic monomer having no reactive functional group (X)" are mixed or partially polymerized to be in a semi-polymerization state, and thereafter the mixture is further mixed with the remaining "metal alkoxide having the reactive functional group (Y)" and polymerized.

When the two kinds of monomers are preliminarily reacted, the polymerization takes from 1 to 8 hours.

The average particle size of the two-component semi-polymerized resin obtained by partially polymerizing (semi-polymerization) the aforementioned two kinds of monomers that are "the acrylic monomers having the reactive functional group (X)" and "the acrylic monomer having no reactive functional group (X)" is preferably in a range from 0.05 to 0.30 µm. When the particle size is smaller 0.05 µm workability improvement effect may becomes small, whereas when the particle size is lager than 0.30 µm, an outer appearance of the resulting coating film may deteriorate. The particle size may be controlled by, e.g., adjusting the composition of the mixture of the two kinds of monomers, and emulsion polymerization conditions.

A weight average molecular weight of the two-component semi-polymerized resin particles is preferably from 6000 to 12000. When the weight average molecular weight is lower than 6000, control of the film thickness tends to be difficult, whereas when the weight average molecular weight is more than 12000, smoothness of the coating film tends to lower.

The resin solid content in the emulsion having the aforementioned composition is preferably from 3 to 20 weight percent. When the resin solid content amount is lower than 3 weight percent, control of the film thickness tends to be difficult, whereas when the resin solid content amount is more than 20 weight percent, smoothness of the coating film tends to slower.

### (Method of preparing resin solution using non-water-based solvent)

As the non-water-based solvent, an organic solvent, such as toluene and ethyl acetate, is used. As the non-water-based solvent, other solvents such as xylene, N-methylpyrrolidone, butyl acetate, aliphatic and/or aromatic compounds having a relatively high boiling point, butyl diglycol acetate, and acetone may also be appropriately used.

As the polymerization initiator, an initiator that generates radicals by application of heat (azo-based initiators and peroxide-based initiators) is used.

The three kinds of monomers or two kinds of preliminarily combined monomers, and the polymerization initiator are dissolved in the non-water-based solvent, so that a resin solution is prepared in which the monomers are polymerized or partially polymerized (semi-polymerization). The concentration of the resin component in the resin solution is preferably from 30 to 60 weight percent, and more preferably 50 weight percent.

If necessary, the liquid may further contain an ultraviolet scattering agent or/and an ultraviolet absorbing agent, in addition to the resin component and the solvent. Examples of the ultraviolet scattering agent may include fine powder of zinc oxide, or titanium oxide. Examples of the ultraviolet absorbing agent may include pigment having an ultraviolet absorbing property, and an acrylic polymer in which benzotriazole group is incorporated at a high concentration. The addition of a small amount of the ultraviolet scattering agent or/and the ultraviolet absorbing agent can further improve the anti-weathering property of the coating layer. When the coating layer has the multilayered structure, it is preferable that the ultraviolet scattering agent or/and the ultraviolet absorbing agent are added to one or more layers of the coating layers. It is further preferable that the ultraviolet scattering agent or/and the ultraviolet absorbing agent are added to two or more coating layers or all of the coating layers.

As the liquid, products having emulsion composition are commercially supplied. Therefore, it is possible to use such products. Examples of the commercially supplied products may include "Silas" (trade name) product manufactured by Toagosei Co., Ltd, and "Cieluster-MK" (trade name) manufactured by Nippon Paint Co., Ltd.

### (Step of forming coating film of liquid)

The coating film of the liquid is formed on one surface or both surfaces of the substrate film 1 (in FIG. 1, both surfaces) such that the thickness of the film after being dried is from 6 to 350 µm. As the method for applying the liquid, known techniques that are generally used, such as a dipping method, a roll coating method, a screen printing method, and a spraying method, may be used. In order to uniformly control the thickness, thin coating layers may be multiply layered so as to achieve a predetermined thickness. When the thin coating layers are multiply layered, a previously applied layer is dried, and thereafter a subsequent layer is applied and then dried, and then a still subsequent layer is applied, and such procedures are repeated.

### (Step of forming coating layer of ternary copolymer layer)

This step includes a coating film drying step of drying the coating film, and a dried coating film curing step of, after drying, finally forming a cured film (the ternary copolymer layer) composed of the ternary copolymer.

### (Step of drying coating film)

In the coating film drying step, the solvent in the coating film of the liquid is vaporized so as to stabilize the shape of the coating film. Drying temperature is preferably from 80°C to 120°C. When the temperature is lower than 80°C, evaporation of the solvent becomes insufficient, whereas when the temperature is higher than 100°C, this step initiates polymerization of the unreacted monomers in the coating film. Time period for drying depends on the drying temperature. For example, the drying time is preferably from 10 minutes to 15 minutes at the drying temperature of 100°C.

### (Step of curing dried coating film)

In this step, the coating film whose shape has been stabilized by drying is cured by polymerizing the monomers that has not been reacted in the coating film. The polymerization temperature of the unreacted monomers is preferably from 80°C to 120°C. When the temperature is lower than 80°C, the polymerization becomes insufficient, whereas when the temperature is higher than 120°C, PET starts shrinking if the layer is formed on PET, and the adhesiveness of the coating film is also adversely affected. Time period for polymerization depends on the polymerization temperature. For example, the polymerization time is preferably from 10 minutes to 15 minutes at the polymerization temperature of 100°C.

### (Characteristics of ternary copolymer layer, and sheet having ternary copolymer layer as coating layer)

The coating layer 2 composed of the ternary copolymer layer has a gas barrier property and an anti-weathering property while maintaining flexibility. Therefore, a sheet having the coating layer 2 functions as a solar cell back surface protection sheet having excellent long-term reliability.

As disclosed in Patent Literature 3, in prior art, polyvinyl alcohol (PVA) has been used as a polymer material having water solubility. PVA has a water vapor permeation rate of 1100 g/m²·24 hr (measurement conditions: 25°C, 90% RH, and thickness of 25 µm). Although PVA has such a poor water vapor barrier property, PVA has good flexibility. In the related-art solar cell back surface protection sheet, an inorganic oxide vapor-deposited film serving as a gas barrier layer alone cannot avoid cracks upon bending. Therefore a film of a flexible polymer such as PVA is layered thereon so as to ensure the gas barrier property while maintaining flexibility against bending. Accordingly, the structure without the inorganic oxide vapor-deposited film is insufficient in gas barrier property. That is, the number of layers increases, and that inhibits control of the total thickness of the sheet.

In the present invention, an acrylic monomer is used as a monomer copolymerizable with a metal alkoxide for the coating layer ensuring the gas barrier property. It is generally known that an acrylic resin polymethyl methacrylate (PMMA), which is the polymer of the monomers, generally has a water vapor permeation rate of 41 g/m²·24 hr (measurement conditions: 25°C, 90% RH, and thickness of 25 µm), and thus has a better gas barrier property than that of PVA.

The measurement values of the water vapor permeation rates of polyvinyl alcohol and polymethyl methacrylate are cited from Takeo Yasuda, "methods of testing dynamic properties of plastic materials and evaluation results <5>", plastics, vol. 51, no. 6, p. 119.

In the present invention, the monomer materials of the ternary copolymer layer for constituting the coating layer are three kinds of monomers that are the acrylic monomer having the reactive functional group (X), the acrylic monomer having no reactive functional group (X), and the metal alkoxide having the reactive functional group (Y) that is reactive with the reactive functional group (X). A liquid containing these three kinds of monomers as the resin component is formed. The liquid is then processed to be the ternary copolymer layer in a form of a film, which is utilized as the coating layer.

In the ternary copolymer layer constituting the coating layer, as illustrated in FIG. 2, two kinds of acrylic monomers are bonded to form a chain. The formed chain of the acrylic polymer maintains flexibility. In the chain of the acrylic polymer, a plurality of functional groups (X) derived from the acrylic monomer having the reactive functional group (X) are present with intervals. The functional group (X) reacts and bonds with the functional groups (Y) of the metal alkoxide. In addition, an M-O bond is formed by hydrolysis of the metal alkoxides each having the reactive functional group (Y). As a result, the ternary copolymer layer acquires a mesh structure. The mesh structure can realize flexibility, and high water vapor barrier property and anti-weathering property. Consequently, the sheet of the present invention is free from a problem of having cracks by bending and consequent remarkable gas barrier property deterioration.

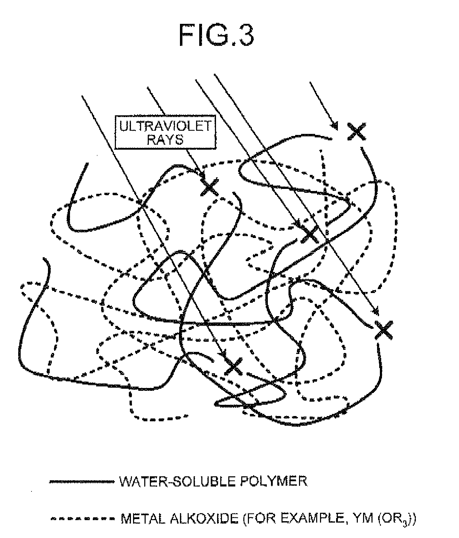

The related-art sheet uses a fluorine resin bonded on the gas barrier layer as a resin film having the anti-weathering property, As illustrated in Table 1, C-F bond energy is 116 kcal, and much stronger than the energy of ultraviolet rays of 96 kcal. However, C-C bond energy of the main chain is 85 kcal, which is weaker than the energy of ultraviolet rays. Therefore, ultraviolet rays cause degradation of the resin. In addition, as illustrated in FIG. 3, the complex of the metal alkoxides of the gas barrier layer and polymer is mere a complex in which the polymer has no chemical bond with the hydrolysis products of the metal alkoxides. Therefore, if the C-C bond of the main chain is severed by ultraviolet rays (as indicated with "X" in FIG. 3), the polymer is degraded by ultraviolet rays. As a result, a problem arises in that the water vapor barrier property markedly deteriorates.

**Table 1**

| Type of energy | Energy (kcal/mol) |
|---|---|
| Ultraviolet rays | 96 |
| C-F bond | 116 |
| C-C bond | 85 |
| Si-O bond | 106 |
| Ti-O bond | 145 |
| Al-O bond | 115 |

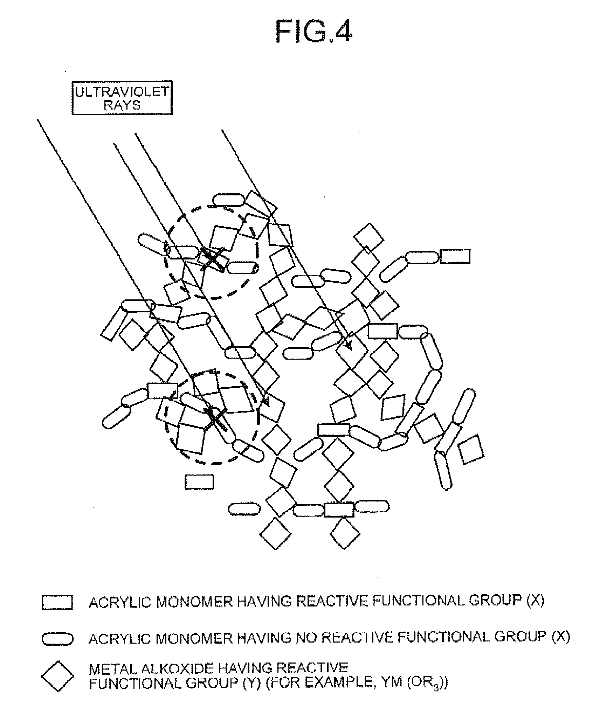

In contrast, in the ternary copolymer layer used as the coating layer of the sheet according to the present invention, as illustrated in FIG. 4, even if the C-C bond of the acrylic polymer (85 kcal) is severed by ultraviolet rays (as indicated with "X" in FIG. 4), the M-O bond formed by the metal alkoxides (106 to 145 kcal) is not severed. Even if the hydrolysis of the metal alkoxides proceeds due to humidity is the air or the polymer and the C-C bond of the acrylic polymer is severed by ultraviolet rays, increase in the number of M-O bonds can cause self-repairing. As a whole, ultraviolet rays cause almost no deterioration.

Furthermore, the ternary copolymer layer bonds to a resin such as PET with a chemical bond, and exhibits excellent adhesiveness, to therefore raise no concern about peeling between the substrate film and the ternary copolymer layer (coating layer). It is considered that the metal alkoxides are hydrolyzed by moisture, resulting in the M-O bonds being formed in a mesh structure, whereas a - CH₂-CHR- bond of an acrylic polymer is rarely hydrolyzed. Consequently, the sheet of the present invention does not have the defect of the related-art sheet having the structure in which a film having an anti-weathering property and a substrate film having a gas barrier property are bonded with an adhesive. That is, the sheet of the present invention is free from a problem of deterioration of the adhesive by hydrolysis and subsequent peeling of the films as a result of deterioration of resin film during its use for a long period of time to allow enter of moisture from outside.

As described above, the sheet according to the present invention can be provided as a solar cell back surface protection sheet excellent in flexibility, an ultra-anti-weathering property, and a water vapor barrier property.

### Examples

In the following examples, 3-glycidoxypropyltriethoxysilane (commonly in Examples 1 to 3), or 3-isocyanatepropyltriethoxysilane (Example 4) was used as the metal alkoxide having the reactive functional group (Y) that is among the three kinds of monomers, i.e., the metal alkoxide having the reactive functional group (Y), the acrylic monomer having the reactive functional group (X) that is reactive with the reactive functional group (Y), and the acrylic monomer having no reactive functional group (X). As the remaining monomers that are the acrylic monomer having the reactive functional group (X) that is reactive with the reactive functional group (Y), and the acrylic monomer having no reactive functional group (X), a commercially available product that is a mixture of these monomers (the base resin of "Cieluster-MK" manufactured by Nippon Paint Co., Ltd) was used (commonly in Examples 1 to 4) .

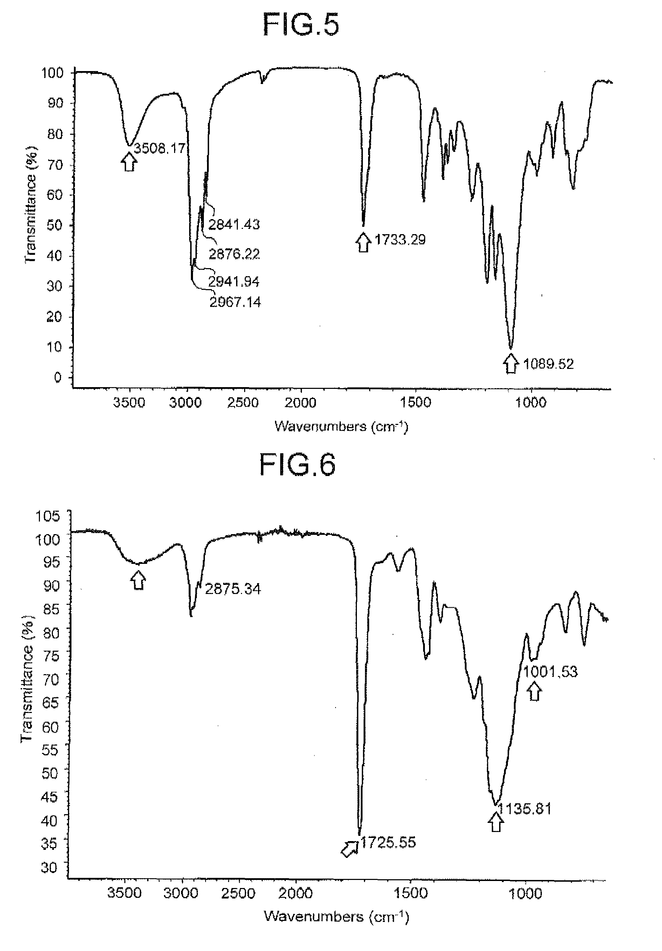

The fact that the aforementioned commercially available product is the mixture of the acrylic monomer having the reactive functional group (X) and the acrylic monomer having no reactive functional group (X) can be confirmed by the infrared total reflection-absorption spectrum of a surface of the dried coating film of the product. The infrared total reflection-absorption spectrum is illustrated in FIG. 5.

As illustrated in FIG. 5, typical peaks appear in wavenumbers from 3650 to 3200 (cm⁻¹), from 1760 to 1715 (cm⁻¹), and from 1150 to 1025 (cm⁻¹). These peaks respectively correspond to the absorption derived from an OH group of a unit including a carboxylic acid (COOH group) or a hydroxyl group (OH) of the acrylic monomer having the reactive functional group (X), the absorption derived from C=O of a unit including ester (COOR) of the acrylic monomer having no reactive functional group (X), and the absorption derived from C-O-C of a unit including ester (COOR) or ether (COC) of the acrylic monomer having no reactive functional group (X).

### (Example 1)

In Example 1 of the present invention, 3-glycidoxypropyltriethoxysilane (1 part by weight) was blended with 15 parts by weight of the base resin of Cieluster-MK, to prepare a liquid.

As described later (in Table 2), a polyethylene terephthalate (PET) having a thickness of 125 µm ("ester film 5000", a trade name of a product manufactured by Toyobo Co., Ltd) was used as the substrate film.

The liquid was applied on both surfaces of the substrate film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the ternary copolymer layer (coating layer) was obtained. The thickness of the resulting film was 20 µm.
The aforementioned process gave a sheet (solar cell back surface protection sheet) that was composed of the substrate film having a thickness of 125 µm, and the coating layers (ternary copolymer layer) having a thickness of 20 µm formed on both surfaces thereof.

The infrared total reflection-absorption spectrum of the ternary copolymer layer is illustrated in FIG. 6.
As illustrated in FIG. 6, typical peaks appear in wavenumbers from 3690 to 3200 (cm⁻¹), from 1760 to 1715 (cm⁻¹), from 1150 to 1025 (cm⁻¹), and from 1100 to 1000 (cm⁻¹).

The peak in the range from 3690 to 3200 (cm⁻¹) corresponds to the absorption derived from OH of a unit including the carboxylic acid (COOH group) or the hydroxyl group (OH) of the acrylic monomer having the reactive functional group (X), and OH of a unit including a silanol group (Si-OH) of an alkoxysilane monomer or the hydroxyl group (OH) produced by a ring-opening reaction of an epoxy group. The peak in the range from 1760 to 1715 (cm⁻¹) corresponds to the absorption derived from C=O of a unit including ester (COOR) of the acrylic monomer having no reactive functional group (X). The peak in the range from 1150 to 1025 (cm⁻¹) corresponds to the absorption derived from C-O-C of a unit including ester (COOR) or ether (COC) of the acrylic monomer having no reactive functional group (X). The peak in the range from 1100 to 1000 (cm⁻¹) corresponds to the absorption derived from Si-O-Si of a unit including a siloxane bond (Si-O) produced by a dehydration-condensation reaction between the silanol groups of the alkoxysilane monomer.

### (Example 2)

In Example 2 of the present invention, as described later (in Table 2), a multilayered film was used as the substrate film. The multilayered film was composed of a polyethylene terephthalate (PET) film having a thickness of 75 µm, and a polyethylene terephthalate (PET) film having a thickness of 12 µm having an vapor-deposited layer formed thereon of silicon oxide or aluminum oxide with a thickness of several tens of nanometers ("Ecosyal VE500" a trade name of a product manufactured by Toyobo Co., Ltd) that are bonded with an alkoxysilane (3-methacryloxypropyltriethoxysilane) adhesive layer having a thickness of 5 µm. As the liquid, a liquid that is the same as the one used in Example 1 was prepared.

The liquid was applied on both surfaces of the substrate film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the ternary copolymer layer (coating layer) was obtained. The thickness of the resulting film was 20 µm,
The aforementioned process gave a sheet (solar cell back surface protection sheet) that was composed of the substrate film having a thickness of 92 µm, and the coating layers (ternary copolymer layer) having a thickness of 20 µm formed on both surfaces thereof.

The infrared total reflection-absorption spectrum of the ternary copolymer layer was taken and found out to be the same as that of FIG. 6.

### (Example 3)

In Example 3 of the present invention, as described later (in Table 2), a multilayered film was used as the substrate film. The multilayered film was composed of a polyethylene terephthalate (PET) film having a thickness of 75 µm, and a polyethylene terephthalate (PET) film having a thickness of 50 µm that are bonded with an alkoxysilane (3-methacryloxypropyltriethoxysilane) adhesive layer having a thickness of 5 µm. As the liquid, a liquid that is the same as the one used in Example 1 was prepared.

The liquid was applied on both surfaces of the substrate film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the ternary copolymer layer (coating layer) was obtained. The thickness of the resulting film was 20 µm.
The aforementioned process gave a sheet (solar cell back surface protection sheet) that was composed of the substrate film having a thickness of 130 µm, and the coating layers (ternary copolymer layer) having a thickness of 20 µm formed on both surfaces thereof.

The infrared total reflection-absorption spectrum of the ternary copolymer layer was taken and found out to be the same as that of FIG. 6.

### (Example 4)

In Example 4 of the present invention, as described later (in Table 2), a polyethylene terephthalate (PET) film having a thickness of 125 µm was prepared as the substrate film.
A liquid was prepared in which 3-isocyanatepropyltriethoxysilane (1 part by weight) was blended with 15 parts by weight of the base resin of Cieluster-MK.

The liquid was applied on both surfaces of the substrate film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the ternary copolymer layer (coating layer) was obtained. The thickness of the resulting film was 20 µm.
The aforementioned process gave a sheet (solar cell back surface protection sheet) that was composed of the substrate film having a thickness of 125 µm, and the coating layers (ternary copolymer layer) having a thickness of 20 µm formed on both surfaces thereof.

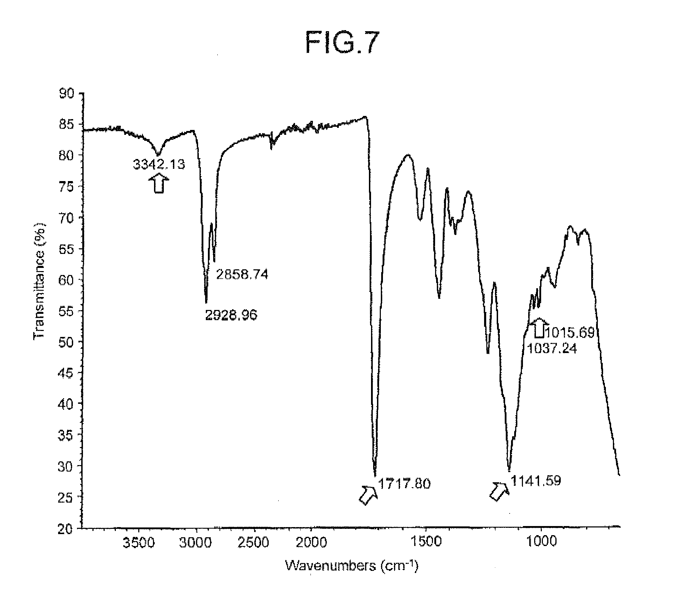

The infrared total reflection-absorption spectrum of the ternary copolymer layer is illustrated in FIG. 7. As illustrated in FIG. 7, typical peaks appear in wavenumbers from 3450 to 3200 (cm⁻¹), from 1760 to 1690 (cm⁻¹), from 1150 to 1025 (cm⁻¹), and from 1100 to 1000 (cm⁻¹). The peak in the range from 3450 to 3200 (cm⁻¹) corresponds to the absorption derived from NH of a unit including an urethane bond produced by the reaction of an isocyanate group (NCO) of the alkoxysilane monomer having the reactive functional group (Y) with the hydroxyl group (OH) of the acrylic monomer having the reactive functional group (X). The peak in the range from 1760 to 1690 (cm⁻¹) corresponds to the absorption derived from C=O of a unit including ester (COOR) of the acrylic monomer having no reactive functional group (X), and C=O of a unit including the urethane bond produced by the reaction of the isocyanate group of the alkoxysilane monomer having the reactive functional group (Y) with the OH group of the acrylic monomer having the reactive functional group (X). The peak in the range from 1150 to 1025 (cm⁻¹) corresponds to the absorption derived from C-O-C of a unit including ester (COOR) or ether (COC) of the acrylic monomer having no reactive functional group (X). The peak in the range from 1100 to 1000 (cm⁻¹) corresponds to the absorption derived from Si-O-Si of a unit including the siloxane bond (Si-O) produced by the dehydration-condensation reaction between the silanol groups of the alkoxysilane monomer.

### (Comparative Example 1)

As Comparative Example 1, a commercially supplied solar cell back surface protection sheet was used. As described later (in Table 3), the sheet of Comparative Example 1 was composed of a layered film (substrate) and fluorine resin films (PVF) having a thickness of 25 µm bonded on both surfaces of the layered film with an adhesive. The layered film was composed of a PET film having a thickness of 125 µm and, as a gas barrier layer, a SiO₂ vapor-deposited film formed on one surface of the PET film with a thickness of 20 nm.

### (Evaluation)

As performance evaluations of the solar cell back surface protection sheets of Examples 1 to 4 and Comparative Example 1, water vapor permeation amounts, tension strength retention rates, and insulation breakdown voltages were measured before and after ultraviolet ray irradiation by a sunshine carbon arc lamp weather tester ("WEL-30OL", a trade name of a product manufactured by Suga Test Instruments Co., Ltd). In addition, the water vapor permeation amounts, the tension strength retention rates, and the insulation breakdown voltages were measured before and after an R-bending (flexibility) endurance test as described in the following. The results are illustrated in Tables 2 and 3.

### (R-bending (flexibility) endurance test)

From a sheet-like sample (A4 size) produced by the aforementioned manner, a piece of the sheet having a size of 15 cm × 15 cm square is cut out. Both edges of the cutout sheet opposing each other are held and thereafter the center portion thereof is bent such that both ends are brought into contact with each other (R-bending). This bending is repeated 100 times.

The water vapor permeation amount was measured by the cup method in accordance with JIS Z0208 under the conditions of temperature at 40°C, and humidity at 90%RH. The tension strength was measured in accordance with JIS K7127 using a universal testing machine (trade name "UH-500kNI") manufactured by Shimadzu Corporation.

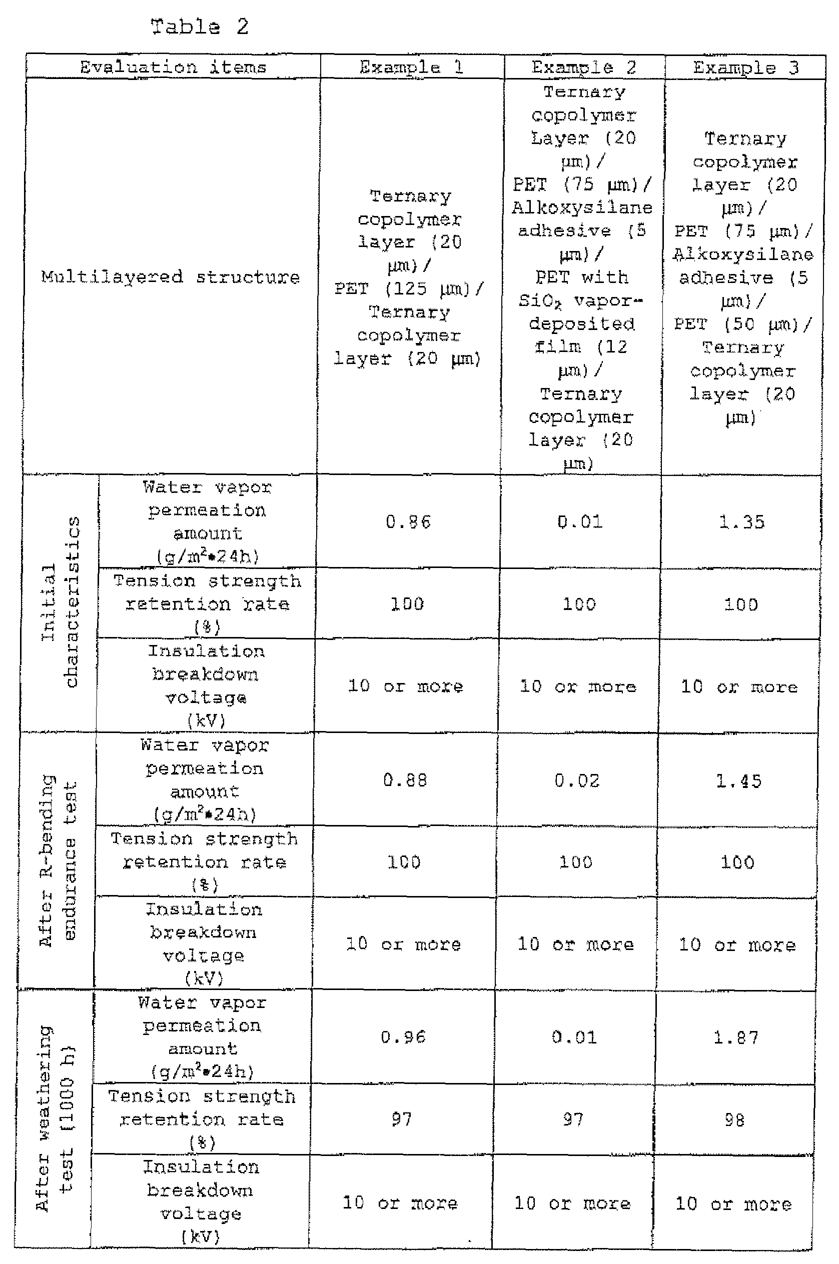

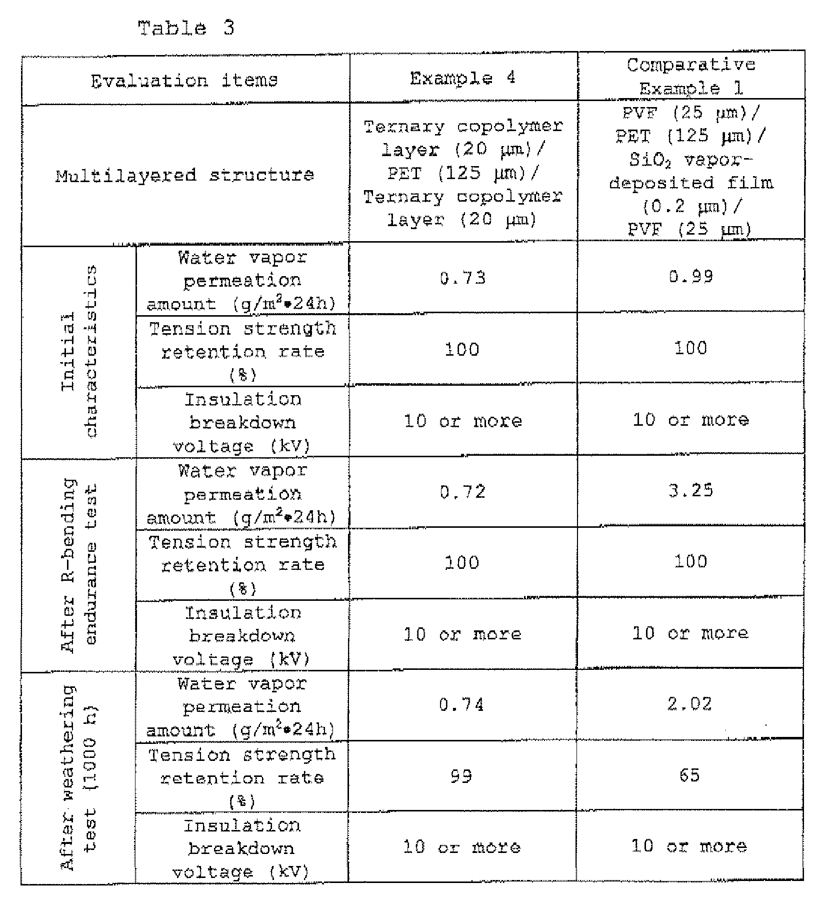

The initial water vapor barrier properties of the sheets of Examples 1, 3, and 4 were nearly equal to that of the sheet of Comparative Example 1 using the oxide vapor-deposited film. The sheet of Example 2 had a very good initial water vapor barrier property. As for the rupture strength after 1000-hour ultraviolet ray irradiation, the tension strength retention rate of the sheet of Comparative Example 1 deteriorated by about 35%, nevertheless the sheet had the fluorine resin film perceived to have an excellent anti-weathering property. In contrast, the tension strength retention rates of the sheets of Examples 1 to 4 remained almost unchanged even after 1000-hour ultraviolet ray irradiation.

The water vapor barrier property of the sheet of Comparative Example 1 deteriorated after 1000-hour ultraviolet ray irradiation. On the other hand, the sheets of Examples 2 and 4 maintained the initial properties, and the sheets of Examples 1 and 3 also maintained good values. In the sheets of Examples 1 to 4, it is conceivable that the metal alkoxides absorbed humidity in the air and moisture in the polymer and were hydrolyzed, enhancing the formation of the mesh structure of the M-O bond. As a result the sheets maintained rupture strengths and the water vapor barrier properties after 1000-hour ultraviolet ray irradiation.

### Industrial Applicability

As described above, the present invention can provide a solar cell back surface protection sheet excellent in a water vapor barrier property, a long-term anti-weathering property, and durability.

### Reference Signs List

- 1: substrate film
- 2: coating layer

## Claims

1. A solar cell back surface protection sheet, comprising:
a substrate film composed of at least one layer; and
a coating layer formed on one surface or both surfaces of the substrate film and composed of at least one layer, wherein
the coating layer is a ternary copolymer layer that is formed by curing a coating film of a liquid containing a resin component consisting of a metal alkoxide having a reactive functional group (Y), an acrylic monomer having a reactive functional group (X). that is reactive with the reactive functional group (Y), and an acrylic monomer having no reactive functional group (X).

2. The solar cell back surface protection sheet according to claim 1, wherein the substrate film is a layered film composed of two or more films bonded with each other with a silane adhesive.

3. The solar cell back surface protection sheet according to claim 1, wherein the substrate film is a single layer, and the single layer is a film having an inorganic oxide vapor-deposited film.

4. The solar cell back surface protection sheet according to claim 1 or 2, wherein the substrate film is composed of two or more layers, and at least one layer of the layers is a film having an inorganic oxide vapor-deposited film.

5. The solar cell back surface protection sheet according to any one of claims 1 to 4, wherein a material of the substrate film is at least one kind selected from a polyester resin, a polyolefin resin, a polystyrene resin, a polyamide resin, a polycarbonate resin, and a polyacrylonitrile resin.

6. The solar cell back surface protection sheet according to any one of claims 1 to 5, wherein, when the coating layer is composed of a single layer, an ultraviolet scattering agent or/and an ultraviolet absorbing agent are mixed in the single layer, and when the coating layer has a multilayered structure, an ultraviolet scattering agent or/and an ultraviolet absorbing agent are mixed in at least one layer of the multilayered structure.

7. A method of manufacturing a solar cell back surface protection sheet, comprising:
preparing a substrate film composed of at least one layer;
preparing a liquid containing a resin component consisting of a metal alkoxide having a reactive functional group (Y), an acrylic monomer having a reactive functional group (X) that is reactive with the reactive functional group (Y), and an acrylic monomer having no reactive functional group (X);
applying the liquid on one surface or both surfaces of the substrate film so as to form a coating film composed of at least one layer; and
curing the coating film composed of at least one layer so as to form a coating layer composed of at least one layer of a ternary copolymer layer.

8. The method of manufacturing a solar cell back surface protection sheet according to claim 7, wherein the liquid is an emulsion obtained by dispersing in a water-based solvent a resin component consisting of a metal alkoxide having a reactive functional group (Y), an acrylic monomer having a reactive functional group (X) that is reactive with the reactive functional group (Y), and an acrylic monomer having no reactive functional group (X).

9. The method of manufacturing a solar cell back surface protection sheet according to claim 7, wherein the liquid is a resin solution obtained by dissolving in a non-water-based solvent a resin component consisting of a metal alkoxide having a reactive functional group (Y), an acrylic monomer having a reactive functional group (X) that is reactive with the reactive functional group (Y), and an acrylic monomer having no reactive functional group (X).

10. The method of manufacturing a solar cell back surface protection sheet according to any one of claims 7 to 9, wherein the substrate film is a layered film composed of two or more films bonded with each other with a silane adhesive.

11. The method of manufacturing a solar cell back surface protection sheet according to any one of claims 7 to 10, wherein the substrate film is a single layer, and the single layer is a film having an inorganic oxide vapour-deposited film.

12. The method of manufacturing a solar cell back surface protection sheet according to any one of claims 7 to 10, wherein the substrate film is composed of two or more layers, and at least one layer of the layers is a film having an inorganic oxide vapor-deposited film.

13. The method of manufacturing a solar cell back surface protection sheet according to any one of claims 7 to 12, wherein a material of the substrate film is at least one kind selected from a polyester resin, a polyolefin resin, a polystyrene resin, a polyamide resin, a polycarbonate resin, and a polyacrylonitrile resin.

14. The method of manufacturing a solar cell back surface protection sheet according to any one of claims 7 to 13, wherein, at the preparation of the liquid, when the ternary copolymer layer is composed of a single layer, an ultraviolet scattering agent or/and an ultraviolet absorbing agent are mixed in a liquid for forming the single layer, and when the ternary copolymer layer has a multilayered structure, an ultraviolet scattering agent or/and an ultraviolet absorbing agent are mixed in a liquid for forming at least one layer of the multilayered structure.
